Europäisches Patentamt

European Patent Office

Office européen des brevets

(19)

(11) **EP 1 138 734 A2**

(12) **EUROPEAN PATENT APPLICATION**

(43) Date of publication:
04.10.2001 Bulletin 2001/40

(51) Int Cl.7: **C09G 1/02**, C09K 3/14, C23F 3/00, H01L 21/321, H01L 21/768

(21) Application number: 01108139.5

(22) Date of filing: 30.03.2001

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **31.03.2000 JP 2000098094**<br><br>(71) Applicant: **JSR Corporation**<br>**Tokyo (JP)**<br><br>(72) Inventors:<br> • **Motonari, Masayuki, JSR Corporation**<br>**Tokyo (JP)** | • **Hattori, Masayuki, JSR Corporation**<br>**Tokyo (JP)**<br> • **Kawahashi, Nobuo, JSR Corporation**<br>**Tokyo (JP)**<br><br>(74) Representative:<br>**Leson, Thomas Johannes Alois, Dipl.-Ing.**<br>**Patentanwälte**<br>**Tiedtke-Bühling-Kinne & Partner,**<br>**Bavariaring 4**<br>**80336 München (DE)** |

(54) **Aqueous dispersion for chemical mechanical polishing of metal films**

(57) It is an object of the present invention to provides an aqueous CMP dispersion with an adequately high initial removal rate, and which, even after repeated polishing, exhibits at least one, and preferably two or more, of the following functions and effects: (1) reduction of performance of polishing pads is suppressed and an adequate removal rate is maintained, (2) generation of pits on polishing surfaces is inhibited, and (3) uneven sections on polishing surfaces are flattened, and satisfactory finished surfaces can be formed with high precision. The aqueous CMP dispersion comprises an abrasive, an organic compound and water. The organic compound with an effect of suppressing reduction of performance of polishing pads may be biphenol, bipyridyl, vinylpyridine, adenine or the like. The organic compound with an effect of inhibiting generation of pits on polishing surfaces may be biphenol, bipyridyl, vinylpyridine, hypoxanthine or the like. The organic compound with an effect of flattening uneven sections on polishing surfaces may be biphenol, bipyridyl, vinylpyridine, salicylaldoxime or the like. The aqueous CMP dispersion of the present invention that contains specific organic compounds has at least one and especially two functions and effects from among that of suppressing reduction of performance of polishing pads, that of suppressing void wearing of polishing surfaces and that of flattening polishing surfaces, as well as a combination of these three functions and effects, even with repeated polishing. The aqueous CMP dispersion is particularly useful for polishing of copper films, and can form satisfactory finished surfaces with high precision.

Fig. 1

**Description**

BACKGROUND OF THE INVENTION

[Field of the Invention]

The present invention relates to an aqueous dispersion for chemical mechanical polishing (hereunder referred to as "aqueous dispersion") which is useful for polishing of metal films of copper and the like. More specifically, the present invention relates to an aqueous dispersion capable of efficient polishing of metal films and the like, which exhibits at least one of the following effects: (1) reduction of performance of polishing pads with repeated polishing is suppressed, (2) generation of pits on polishing surfaces is inhibited, and (3) uneven sections on polishing surfaces are flattened.

[Prior Art]

Improvements in degrees of semiconductor device integration and increased multilayer wiring have led to the introduction of chemical mechanical polishing techniques for polishing of working films and the like. This involves forming wiring by embedding a wiring material such as tungsten, aluminum or copper in a hole or trench formed in an insulation film of a process wafer, and then polishing to remove the excess wiring material. In this polishing technique, the chemical action and mechanical polishing must be effectively incorporated together. When the chemical action is suppressed and a hard abrasive consisting of inorganic particles of alumina or zirconia is used, it is possible to make a polishing agent with a high initial removal rate. By increasing the chemical action of the polishing agent it is possible to provide a polishing agent with an even higher removal rate.

In Japanese unexamined patent Publication No. Hei-8-83780 there is described a polishing agent that suppresses dishing and the like, has a high removal rate and allows formation of highly reliable conductive films. The polishing agent contains a chemical reagent such as benzotriazole. Also, Japanese Unexamined Patent Publication No. Hei-10-116804 discloses a polishing agent capable of flattening with high efficiency by preventing re-adhesion of copper onto polishing surfaces. The polishing agent comprises benzotriazole, benzothiazole, benzimidazole or the like.

However, when the chemical action is suppressed and a hard abrasive is used, repeated polishing causes reduction of performance of polishing pads due to accumulation of polishing residue and the like in the open voids on the polishing pad surfaces, resulting in the problem of a gradually lower removal rate as time progresses. When the chemical action is too strong, pits tend to occur in the polishing surface. If the embedded wiring material is not sufficiently flattened before formation of the wiring, the local dishing and erosion becomes significant and it is no longer possible to obtain a satisfactory finished surface with high precision. In the unexamined patent publications cited above, there is no disclosure or suggestion regarding a polishing agent with either or both an effect of inhibiting generation of pits on polishing surfaces and/or an effect of preventing reduction of performance of polishing pads, while there is also no clear recognition of the need for flattening of surfaces of copper films and the like prior to wiring formation.

SUMMARY OF THE INVENTION

It is an object of the present invention to overcome the aforementioned problems of the prior art by providing an aqueous dispersion for chemical mechanical polishing with an adequately high initial removal rate, and which, even after repeated polishing, exhibits at least one, and preferably two or more, of the following functions and effects: (1) reduction of performance of polishing pads is suppressed and an adequate removal rate is maintained, (2) generation of pits on polishing surfaces is inhibited, and (3) uneven sections on polishing surfaces are flattened, and satisfactory finished surfaces can be formed with high precision.

The present invention is as described below.

1. An aqueous dispersion for chemical mechanical polishing comprising an abrasive, an organic compound with an effect of suppressing reduction of performance of polishing pads, and water, wherein the aqueous dispersion for chemical mechanical polishing being characterized in that said organic compound is at least one from among (1) biphenol, (2) bipyridyl, (3) vinylpyridine, (4) adenine, (5) a heterocyclic compound with a heteropentacycle, with no benzene ring forming the skeleton, and with a functional group, (6) a heterocyclic compound with a heteropentacycle, with a benzene ring forming the skeleton and with a functional group containing no sulfur atoms, (7) a heterocyclic compound with a heterohexacycle bearing two or more hetero atoms and with either or both a functional group and/or a benzene ring forming the skeleton, and a derivative of any of compounds (1) through (7).

2. An aqueous dispersion for chemical mechanical polishing according to 1. above, wherein the heterocyclic compound with a heteropentacycle, with no benzene ring forming the skeleton, and with a functional group is at least one selected from among 7-hydroxy-5-alkyl-1,3,4-triazaindolizine, 2-amino-1,3,4-thiadiazole, lH-tetrazole-1-acetic acid, 5-alkyl-1,3,4-thiadiazole-2-thiol, 4-amino-1,2,4-triazole, 5-amino-1H-tetrazole, 2-mercaptothiazoline and 4-amino-3-hydrazino-5-mercapto-1,2,4-triazole, said heterocyclic compound with a heteropentacycle, with a benzene ring forming the skeleton and with a functional group containing no sulfur atoms is either or both 2-aminobenzothiazole and/or 2-amino-6-alkylbenzothiazole, and said heterocyclic compound with a heterohexacycle bearing two or more hetero atoms and with either or both a functional group and/or a benzene ring forming the skeleton is at least one from among 3-amino-5,6-dialkyl-1,2,4-triazine, 2,3-dicyano-5-alkylpyrazine, 2,4-diamino-6-diallylamino-1,3,5-triazine and phthalazine.

3. An aqueous dispersion for chemical mechanical polishing characterized by comprising an abrasive, an organic compound with an effect of inhibiting generation of pits on polishing surfaces, and water.

4. An aqueous dispersion for chemical mechanical polishing according to 3. above, wherein said organic compound is at least one from among (1) biphenol, (2) bipyridyl, (3) vinylpyridine, (4) hypoxanthine, (5) guanine, (6) salicylaldoxime, (7) a compound with a total of two or more amino groups and/or hydroxyl groups bonded to an alkylene group, (8) a compound with a total of two or more amino groups and/or hydroxyl groups bonded to a benzene ring, (9) a heterocyclic compound with a heteropentacycle and with no benzene ring forming the skeleton, (10) a heterocyclic compound with a heteropentacycle and with a benzene ring forming the skeleton, (11) a heterocyclic compound with a heterohexacycle bearing two or more hetero atoms and with either or both a functional group and/or a benzene ring forming the skeleton, and a derivative of any of compounds (1) through (11).

5. An aqueous dispersion for chemical mechanical polishing according to 4. above, wherein said compound with a total of two or more amino groups and/or hydroxyl groups bonded to an alkylene group is phenylenediamine, said compound with a total of two or more amino groups and/or hydroxyl groups bonded to a benzene ring is at least one from catechol and aminophenol, said heterocyclic compound with a heteropentacycle and with no benzene ring forming the skeleton is at least one selected from among 7-hydroxy-5-alkyl-1,3,4-triazaindolizine, 2-amino-1,3,4-thiadiazole, 1-(2-dialkylaminoethyl)-5-mercaptotetrazole, bismuthiol, 5-alkyl-1,3,4-thiadiazole-2-thiol, 3-mercapto-1,2,4-triazole, 4-amino-1,2,4-triazole, 5-amino-1H-tetrazole and triazole, said heterocyclic compound with a heteropentacycle and with a benzene ring forming the skeleton is at least one from among 5-alkyl-1H-benzotriazole, 2-(2-benzotriazolyl)-p-cresol, 2,1,3-benzothiadiazole, benzimidazole, benzotriazole, mercaptobenzothiazole and benzofloxane, and said heterocyclic compound with a heterohexacycle bearing two or more hetero atoms and with either or both a functional group and/or a benzene ring forming the skeleton is at least one from among benzoguanamine, phthalazine and thiocyanuric acid.

6. An aqueous dispersion for chemical mechanical polishing characterized by comprising an abrasive, an organic compound with an effect of flattening uneven sections on polishing surfaces, and water.

7. An aqueous dispersion for chemical mechanical polishing according to 6. above, wherein said organic compound is at least one from among (1) biphenol, (2) bipyridyl, (3) vinylpyridine, (4) salicylaldoxime, (5) a compound with a total of two or more amino groups and/or hydroxyl groups bonded to an alkylene group, (6) a compound with a total of two or more amino groups and/or hydroxyl groups bonded to a benzene ring, (7) a heterocyclic compound with a heteropentacycle, with no benzene ring forming the skeleton, and with a functional group, (8) a heterocyclic compound with a heteropentacycle, with a benzene ring forming the skeleton and with a functional group, (9) a heterocyclic compound with a heterohexacycle bearing two or more hetero atoms and with either or both a functional group and/or a benzene ring forming the skeleton, and a derivative of any of compounds (1) through (9).

8. An aqueous dispersion for chemical mechanical polishing according to 7. above, wherein said compound with a total of two or more amino groups and/or hydroxyl groups bonded to an alkylene group is phenylenediamine, said compound with a total of two or more amino groups and/or hydroxyl groups bonded to a benzene ring is at least one from catechol and aminophenol, said heterocyclic compound with a heteropentacycle, with no benzene ring forming the skeleton and with a functional group is at least one selected from among 7-hydroxy-5-alkyl-1,3,4-triazaindolizine, 2-amino-1,3,4-thiadiazole, 4,5-dicyanoimidazole, 5-alkyl-1,3,4-thiadiazole-2-thiol, 1-phenyl-5-mercapto-1H-tetrazole, 2-amino-4,5-dicyano-1H-imidazole, 4-amino-1,2,4-triazole, 5-amino-1H-tetrazole, 3-mercapto-4-methyl-4H-1,2,4-triazole and 1H-tetrazole, said heterocyclic compound with a heteropentacycle, with a benzene ring forming the skeleton and with a functional group is at least one from among mercaptobenzothiazole, benzofloxane and 2,1,3-benzothiadiazole, and said heterocyclic compound with a heterohexacycle bearing two or more hetero atoms and with either or both a functional group and/or a benzene ring forming the skeleton is phthalazine.

9. An aqueous dispersion for chemical mechanical polishing characterized by comprising an abrasive, an organic compound with an effect of suppressing reduction of performance of polishing pads and an effect of inhibiting generation of pits on polishing surfaces, and water.

10. An aqueous dispersion for chemical mechanical polishing characterized by comprising an abrasive, an organic compound with an effect of suppressing reduction of performance of polishing pads and an effect of flattening uneven sections on polishing surfaces, and water.

11. An aqueous dispersion for chemical mechanical polishing characterized by comprising an abrasive, an organic compound with an effect of inhibiting generation of pits on polishing surfaces and an effect of flattening uneven sections on polishing surfaces, and water.

12. An aqueous dispersion for chemical mechanical polishing characterized by comprising an abrasive, an organic compound with an effect of suppressing reduction of performance of polishing pads, an effect of inhibiting generation of pits on polishing surfaces and an effect of flattening uneven sections on polishing surfaces, and water.

13. An aqueous dispersion for chemical mechanical polishing according to any one of 9. to 12. above, wherein said organic compound is at least one from among (1) biphenol, (2) bipyridyl, (3) vinylpyridine, (4) hypoxanthine, (5) adenine, (6) guanine, (7) salicylaldoxime, (8) copperon, (9) cysteine, (10) thiourea, (11) a compound with a total of two or more amino groups and/or hydroxyl groups bonded to an alkylene group, (12) a compound with a total of two or more amino groups and/or hydroxyl groups bonded to a benzene ring, (13) a heterocyclic compound with a heteropentacycle and with no benzene ring forming the skeleton, (14) a heterocyclic compound with a heteropentacycle and with a benzene ring forming the skeleton, (15) a heterohexacyclic compound bearing two or more hetero atoms, and a derivative of any of compounds (1) through (15).

14. An aqueous dispersion for chemical mechanical polishing according to 13. above, wherein said organic compound is at least one from among (1) biphenol, (2) bipyridyl, (3) vinylpyridine, (4) hypoxanthine, (5) adenine, (6) guanine, (7) a heterocyclic compound with a heteropentacycle, with no benzene ring forming the skeleton, and with a functional group, (8) a heterocyclic compound with a heteropentacycle, with a benzene ring forming the skeleton, and with a sulfur-lacking functional group, (9) a heterohexacyclic compound bearing two or more hetero atoms and either or both a functional group and/or a benzene ring forming the skeleton, and a derivative of any of compounds (1) through (9).

15. An aqueous dispersion for chemical mechanical polishing according to 9. or 10. above, wherein said organic compound is at least one from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

16. An aqueous dispersion for chemical mechanical polishing according to 11. above, wherein said organic compound is at least one from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine, 5-amino-H-tetrazole, mercaptobenzothiazole, benzofloxane, 2,1,3-benzothiadiazole, catechol and aminophenol.

17. An aqueous dispersion for chemical mechanical polishing according to 12. above, wherein said organic compound is at least one from among 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

18. An aqueous dispersion for chemical mechanical polishing according to any one of 1. to 17. above, wherein the ratio $(S_{10}/S_1)$ of the tenth removal rate $(S_{10})$ to the first removal rate $(S_1)$ for 10 repeated chemical mechanical polishing operations of a copper film under the following conditions is 0.9 or greater.

Polishing conditions: Polishing pressure, 250 $g/cm^2$; Table rotation speed, 45 rpm; head rotation speed, 45 rpm; Aqueous dispersion supply rate, 50 ml/min; Polishing time, 3 minute; Porous polyurethane polishing pad.

19. An aqueous dispersion for chemical mechanical polishing according to any one of 1. to 18. above, wherein said metal film is a copper film.

Defined in the present invention, the aqueous dispersion for chemical mechanical polishing contains specific organic compounds with at least one and especially two functions and effects from among that of suppressing reduction of performance of polishing pads, that of suppressing void wearing of polishing surfaces and that of flattening polishing surfaces, as well as a combination of these three functions and effects, even with repeated polishing. The aqueous dispersion of the invention is particularly useful for polishing of copper films, and can form satisfactory finished surfaces with high precision.

BRIEF DESCRIPTION OF THE DRAWINGS

Fig. 1 is a schematic view illustrative of flattening of a polishing surface.
Fig. 2 is a figure shown by a scanning electron microscope photograph of a polishing surface polished using the aqueous dispersion for chemical mechanical polishing of Example 6.
Fig. 3 is a figure shown by a scanning electron microscope photograph of a polishing surface polished using the aqueous dispersion for chemical mechanical polishing of Comparative Example 1.

DETAILED DESCRIPTION OF THE PREFERRED EMBODIMENTS

The aqueous dispersion for chemical mechanical polishing of the present invention is characterized by comprising an abrasive, an organic compound with an effect of suppressing reduction of performance of polishing pads, and water.

The aqueous dispersion for chemical mechanical polishing of the present invention is further characterized by comprising an abrasive, an organic compound with an effect of inhibiting generation of pits on polishing surfaces, and water, and is still further characterized by comprising an abrasive, an organic compound with an effect of flattening uneven sections on polishing surfaces, and water.

The aqueous dispersion for chemical mechanical polishing of the present invention is still further characterized by an organic compound with at least two effects from among an effect of suppressing reduction of performance of polishing pads, an effect of inhibiting generation of pits on polishing surfaces and an effect of flattening uneven sections on polishing surfaces, and water.

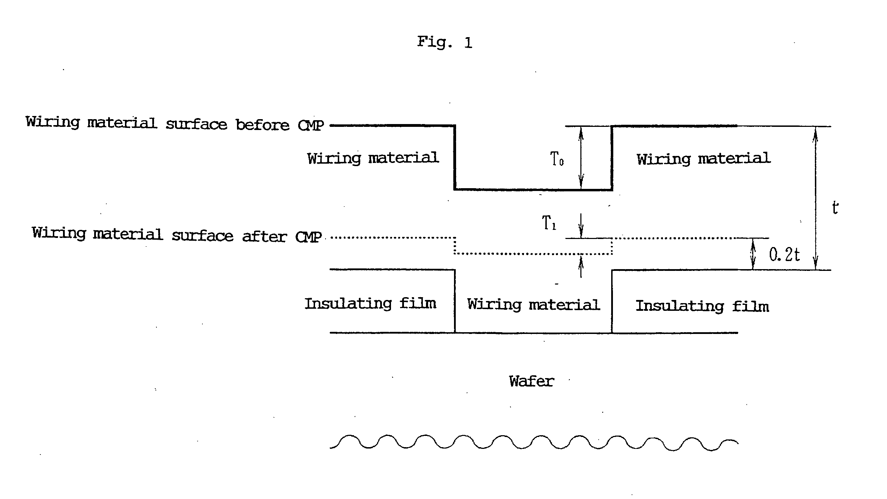

The flattening of uneven sections on polishing surfaces refers to a situation such that $T_1/T_0 = 0\text{-}0.2$ (where $T_1$ is the unevenness after polishing), for a wiring material (thickness: t) of copper or the like embedded in a hole or groove formed in an insulating film on a wafer such as a silicon wafer when 80% polished from the pre-polishing unevenness ($T_0$) on the surface of the wiring material (i.e., the thickness of the wiring material on the insulating film is 0.2 t), such as shown in Fig. 1 which is a schematic view of the cross-section during chemical mechanical polishing. The ratio $T_1/T_0$ is preferably 0-0.1, and especially 0-0.05.

These aqueous dispersions can be used for polishing of various types of working films formed on semiconductor boards in manufacturing processes for semiconductor devices such as VLSIs and the like. As working films there may be mentioned pure tungsten films, pure aluminum films or pure copper films, as well as alloy films of tungsten, aluminum or copper with other metals. There may also be mentioned barrier metal layers comprising metals such as tantalum and titanium. The organic compounds with the specific effect included in the aqueous dispersions of the invention have high affinity for copper, such that the aqueous dispersions are particularly useful for polishing of copper. Here, copper includes not only pure copper, but also alloys containing at least 95 wt% copper, such as copper-silicon, copper-aluminum and the like.

The following specific compounds may be used for the present invention, as the "organic compound" with an effect of suppressing reduction of performance of polishing pads.

As the organic compound there may be used one or more from among (1) biphenol, (2) bipyridyl, (3) vinylpyridine, (4) adenine, (5) 7-hydroxy-5-alkyl-1,3,4-triazaindolizine, 2-amino-1,3,4-thiadiazole, 1H-tetrazole-1-acetic acid, 5-alkyl-1,3,4-thiadiazole-2-thiol, 4-amino-1,2,4-triazole, 5-amino-1H-tetrazole, 2-mercaptothiazoline and 4-amino-3-hydrazino-5-mercapto-1,2,4-triazole, (6) 2-aminobenzothiazole and 2-amino-6-alkylbenzothiazole, and (7) 3-amino-5,6-dialkyl-1,2,4-triazine, 2,3-dicyano-5-alkylpyrazine, 2,4-diamino-6-diallylamino-1,3,5-triazine and phthalazine.

The effect of suppressing reduction of performance of polishing pads can be evaluated by determining that the ratio ($S_{10}/S_1$) of the tenth removal rate ($S_{10}$) to the first removal rate ($S_1$) for 10 repeated chemical mechanical polishing operations of a copper film under the following conditions is 0.9 or greater. The ratio $S_{10}/S_1$ is more preferably 0.95 or greater, and even more preferably 0.98 or greater.

Polishing conditions: Polishing pressure, 250 g/cm$^2$; Table rotation speed, 45 rpm; head rotation speed, 45 rpm; Aqueous dispersion supply rate, 50 ml/min; Polishing time, 3 minute; Porous polyurethane polishing pad.

The following specific compounds may be used for the present invention, as the "organic compound" with an effect of inhibiting generation of pits on polishing surfaces.

As the organic compound there may be used one or more from among (1) biphenol, (2) bipyridyl, (3) vinylpyridine, (4) hypoxanthine, (5) guanine, (6) salicylaldoxime, (7) phenylenediamine, (8) catechol and aminophenol, (9) 7-hydroxy-5-alkyl-1,3,4-triazaindolizine, 2-amino-1,3,4-thiadiazole, 1-(2-dialkylaminoethyl)-5-mercaptotetrazole, bismuthiol, 5-alkyl-1,3,4-thiadiazole-2-thiol, 3-mercapto-1,2,4-triazole, 4-amino-1,2,4-triazole, 5-amino-1H-tetrazole and triazole, (10) 5-alkyl-1H-benzotriazole, 2-(2-benzotriazolyl)-p-cresol, 2,1,3-benzothiadiazole, benzimidazole, benzotriazole, mercaptobenzothiazole and benzofloxane, and (11) benzoguanamine, phthalazine and thiocyanuric acid.

The following specific compounds may be used for the present invention, as the "organic compound" with an effect of flattening uneven sections on polishing surfaces.

As the organic compound there may be used one or more from among (1) biphenol, (2) bipyridyl, (3) vinylpyridine, (4) salicylaldoxime, (5) phenylenediamine, (6) catechol and aminophenol, (7) 7-hydroxy-5-alkyl-1,3,4-triazaindolizine, 2-amino-1,3,4-thiadiazole, 4,5-dicyanoimidazole, 5-alkyl-1,3,4-thiadiazole-2-thiol, 1-phenyl-5-mercapto-1H-tetrazole, 2-amino-4,5-dicyano-lH-imidazole, 4-amino-1,2,4-triazole, 5-amino-1H-tetrazole, 3-mercapto-4-methyl-4H-1,2,4-triazole and 1H-tetrazole, (8) mercaptobenzothiazole, benzofloxane and 2,1,3-benzothiadiazole, and (9) phthalazine.

The following specific compounds may be used for the present invention, [1] as the "organic compound" with an effect of suppressing reduction of performance of polishing pads and an effect of inhibiting generation of pits on polishing surfaces, [2] as the "organic compound" with an effect of suppressing reduction of performance of polishing pads and an effect of flattening uneven sections on polishing surfaces, [3] as the "organic compound" with an effect of inhibiting generation of pits on polishing surfaces and an effect of flattening uneven sections on polishing surfaces, and [4] as the "organic compound" with an effect of suppressing reduction of performance of polishing pads, an effect of inhibiting generation of pits on polishing surfaces and an effect of flattening uneven sections on polishing surfaces.

As the organic compound there may be used one or more from among (1) biphenol, (2) bipyridyl, (3) vinylpyridine, (4) hypoxanthine, (5) adenine, (6) guanine, (7) salicylaldoxime, (8) copperon, (9) cysteine, (10) thiourea, (11) a compound with a total of two or more amino groups and/or hydroxyl groups bonded to an alkylene group, (12) a compound with a total of two or more amino groups and/or hydroxyl groups bonded to a benzene ring, (13) a heterocyclic compound with a heteropentacycle and with no benzene ring forming the skeleton, (14) a heterocyclic compound with a heteropentacycle and with a benzene ring forming the skeleton, (15) a heterohexacyclic compound bearing two or more hetero atoms, and a derivative of any of compounds (1) through (15).

The following specific compounds are particularly preferred for use defined in the present invention as the "organic compound" with an effect of suppressing reduction of performance of polishing pads and an effect of inhibiting generation of pits on polishing surfaces, and as the "organic compound" with an effect of suppressing reduction of performance of polishing pads and an effect of flattening uneven sections on polishing surfaces.

As preferred organic compounds there may be used one or more from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

The following specific compounds are particularly preferred for use defined in the present invention as the "organic compound" with an effect of inhibiting generation of pits on polishing surfaces and an effect of flattening uneven sections on polishing surfaces.

As preferred organic compounds there may be used one or more from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine, 5-amino-H-tetrazole, mercaptobenzothiazole, benzofloxane, 2,1,3-benzothiadiazole, catechol and aminophenol.

The following specific compounds are particularly preferred for use defined in the present invention as the "organic compound" with an effect of suppressing reduction of performance of polishing pads, an effect of inhibiting generation of pits on polishing surfaces, and an effect of flattening uneven sections on polishing surfaces.

As preferred organic compounds there may be used one or more from among 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

These organic compounds may be included at 0.001-5 parts, especially 0.005-3 parts and more preferably 0.01-2 parts, in 100 parts of the aqueous dispersion. If the organic compound content is less than 0.001 part, it is sometimes impossible to obtain the effect on reduction of performance of polishing pads, generation of pits on polishing surfaces and flattening of uneven sections on polishing surfaces. On the other hand, no further excellent effect is achieved even if it exceeds 5 parts, and therefore addition in excess of 5 parts is unnecessary.

The "abrasive" used for the present invention may be inorganic particles, organic particles or organic/inorganic composite particles.

As inorganic particles there may be used particles composed of silicon or metal oxides such as silica, alumina, ceria, titania, zirconia, iron oxide, manganese oxide or the like.

As organic particles there may be used particles composed of thermoplastic resins such as (1) polystyrene and styrene-based copolymers, (2) (meth)acrylic resins such as polymethyl methacrylate, and acrylic-based copolymers, (3) polyvinyl chloride, polyacetals, saturated polyesters, polyamides, polyimides, polycarbonates and phenoxy resins, and (4) polyolefins such as polyethylene, polypropylene, poly-1-butene, poly-4-methyl-1-pentene, and olefin-based copolymers.

Also, the organic particles, a polymer with a crosslinked structure obtained by copolymerization of styrene, methyl methacrylate or the like with divinylbenzene, ethyleneglycol dimethacrylate or the like may also be used. The degree of crosslinking can be used to adjust the hardness of the organic particles.

There may also be used organic particles composed of thermosetting resins such as phenol resins, urethane resins, urea resins, melamine resins, epoxy resins, alkyd resins and unsaturated polyester resins.

These inorganic particles and organic particles may be used alone or in combinations of two or more.

Organic/inorganic composite particles may also be used as the abrasive. The organic/inorganic composite particles may have the organic particles and inorganic particles formed integrally to an extent so as not to easily separate during the polishing process, and there are no particular restrictions on their types or structures.

As composite particles there may be used particles formed by polycondensation of an alkoxysilane, aluminum alkoxide, titanium alkoxide or the like in the presence of polymer particles of polystyrene, polymethyl methacrylate or the like, and bonding of polysiloxane or the like on at least the surface of the polymer particles. The resulting polycondensate may be directly bonded to the functional group of the polymer particles, or it may be bonded via a silane coupling agent or the like.

The polycondensate does not necessarily need to be chemically bonded to the polymer particles, and the three-dimensionally formed polycondensate may by physically held on the surface of the polymer particles. Silica particles or alumina particles may also be used instead of an alkoxysilane. These may also be held by intertwining with the polysiloxane, or they may be chemically bonded to the polymer particles by their functional groups, such as hydroxyl groups.

In an aqueous dispersion containing organic particles and inorganic particles with zeta potentials of opposite signs, the composite particles used may have their particles bonded by electrostatic force.

The zeta potentials of polymer particles are usually negative across the entire pH range, or across a wide pH range except for the low pH range; however, by using polymer particles with carboxyl groups, sulfonic acid groups or the like, it is possible to obtain polymer particles with a more definite negative zeta potential. Polymer particles with amino groups and the like have a positive zeta potential in specific pH ranges.

However, the zeta potentials of inorganic particles are highly pH-dependent and have an isoelectric point at which the potential is zero; the sign of the zeta potential reverses at around that point.

Thus, by combining specific organic particles and inorganic particles and mixing them in a pH range at which their zeta potentials are opposite signs, it is possible to form an integral composite of the organic particles and inorganic particles by electrostatic force. During the mixing, the zeta potentials may be of the same sign, and the pH adjusted thereafter to give zeta potentials of opposite signs, thereby allowing integration of the organic particles and inorganic particles.

The composite particles used may be prepared by polycondensation of an alkoxysilane, aluminum alkoxide, titanium alkoxide or the like in the presence of particles integrally composed in this manner by electrostatic force, and bonding of polysiloxane or the like on at least the surface of the particles to form a composite.

The composite particles used may be of one type, or they may be a combination of two or more types. The composite particles may also be used in combination with either or both inorganic particles and organic particles.

The mean particle size of the inorganic particles and organic particles is preferably 0.001-3 μm. A mean particle size of less than 0.001 μm will not give an aqueous dispersion with a sufficiently high removal rate. On the other hand, a mean particle size of greater than 3 μm may result in precipitation and separation of the abrasive, hampering efforts to achieve a stable aqueous dispersion. The mean particle size is more preferably 0.005-2.0 μm, and even more preferably 0.01-1.0 μm. An abrasive with a mean particle size in this range can give a stable aqueous dispersion for chemical mechanical polishing that allows polishing at a sufficient removal rate without precipitation and separation of the particles. The mean particle size may be measured by observation under a transmission electron microscope.

The abrasive content may be 0.3-15 parts by weight (hereunder referred to simply as "parts"), but is preferably 0.5-8 parts and more preferably 3-6 parts, to 100 parts of the aqueous dispersion. If the abrasive content is less than 0.3 part it may not be possible to achieve a sufficient removal rate, while its content is preferably not more than 15 parts because the cost will be increased and the stability of the aqueous dispersion will be reduced.

The form of the inorganic particles, organic particles and composite particles functioning as the abrasive is preferably spherical. Here, "spherical" means roughly spherical with no acute angle portions, and not necessarily near-perfect spheres. Using a spherical abrasive will allow polishing at an adequate rate, with no scratching of the polishing surface during polishing.

The pH of the aqueous dispersion is preferably adjusted to the range of 2-12, more preferably 3-11, even more preferably 5-10. The pH adjustment may be accomplished with an acid such as nitric acid or sulfuric acid, or with an alkali such as potassium hydroxide, sodium hydroxide or ammonia. If the pH of the aqueous dispersion is lower than 2, the etching effect on working films of copper or the like is stronger, thus tending to produce more dishing and erosion. On the other hand, if the pH is above 12, interlayer insulating films are excessively polished, and a satisfactory wiring pattern cannot be obtained.

By including an acid in the aqueous dispersion for chemical mechanical polishing of the invention, it is possible to further improve the dispersability, stability and removal rate. The acid is not particularly restricted, and any organic acid or inorganic acid may be used. As organic acids there may be mentioned para-toluenesulfonic acid, dodecylbenzenesulfonic acid, isoprenesulfonic acid, gluconic acid, lactic acid, citric acid, tartaric acid, malic acid, glycolic acid, malonic acid, formic acid, oxalic acid, succinic acid, fumaric acid, maleic acid and phthalic acid. These organic acids may be used alone or in combinations of two or more. As inorganic acids there may be mentioned nitric acid, hydrochloric acid and sulfuric acid, and any one or more of these may be used. An organic acid and an inorganic acid may also be used in combination.

The contents of these acids may 0.01-5 parts, especially 0.1-3 parts and more preferably 0.3-2 parts in 100 parts of the aqueous dispersion. With an acid content within the range of 0.01-5 parts it is possible to provide an aqueous dispersion with excellent dispersability and sufficient stability, while it is also preferred from the standpoint of improving the removal rate.

When the working film is composed of a metal, an oxidizing agent may be added to the aqueous dispersion within a range that does not cause excessive etching, to vastly improve the removal rate. As oxidizing agents there may be used those selected as appropriate depending on the electrochemical properties of the metal layer of the working surface, based on a Pourbaix diagram, for example.

As examples of specific oxidizing agents there may be mentioned hydrogen peroxide, organic peroxides such as peracetic acid, perbenzoic acid, tert-butylhydroperoxide, and the like, permanganate compounds such as potassium permanganate, and the like, bichromate compounds such as potassium bichromate, and the like, halogenate compounds such as potassium iodate, and the like, nitric compounds such as nitric acid, iron nitrate, and the like, perhalogenate compounds such as perchloric acid, and the like, transition metal salts such as potassium ferricyanide, and the like, persulfuric compounds such as ammonium persulfate, and the like, and heteropoly acids. Particularly preferred among these oxidizing agents are hydrogen peroxide and organic peroxides which contain no metals and whose decomposition products are harmless. Including such oxidizing agents can give an even more vastly improved removal rate.

The content of the oxidizing agent may be up to 10 parts, especially 0.01-5 parts and more preferably 0.05-2 parts, in 100 parts of the aqueous dispersion. Since sufficient improvement in the removal rate can be achieved if the oxidizing agent is added at 10 parts, there is no need to add it at greater than 10 parts.

Various additives may also be added to the aqueous dispersion as necessary in addition to the aforementioned oxidizing agents. This can further improve the stability of the dispersion, increase the polishing speed, and adjust the difference in polishing speeds when polishing films of different hardness, such as in the case of polishing two or more types of working films. Specifically, addition of an organic acid or inorganic acid can give a more highly stable aqueous dispersion. As organic acids there may be used formic acid, acetic acid, oxalic acid, malonic acid, succinic acid, benzoic acid, or the like. As inorganic acids there may be used nitric acid, sulfuric acid, phosphoric acid, or the like. Organic acids are particularly preferred as acids used to increase the stability. These acids can also be used to increase the removal rate.

Addition of these acids, or alkali metal hydroxides ammonia and the like for adjustment of the pH can improve the dispersability and stability of the aqueous dispersion.

As alkali metal hydroxides there may be used sodium hydroxide and potassium hydroxide mentioned above, as well as rubidium hydroxide, cesium hydroxide and the like. Adjustment of the pH of the aqueous dispersion can increase the removal rate, and the pH is preferably determined as appropriate within the range where the abrasive can exist stably in consideration of the electrochemical properties of the working surface, the dispersability and stability of the polymer particles and the removal rate.

The aqueous dispersion may also contain a polyvalent metal ion with the effect of promoting the function of the oxidizing agent such as hydrogen peroxide, and can thus further improve the removal rate.

As polyvalent metal ions there may be mentioned metal ions such as aluminum, titanium, vanadium, chromium, manganese, iron, cobalt, nickel, copper, zinc, germanium, zirconium, molybdenum, tin, antimony, tantalum, tungsten, lead and cerium. Any one of these may be used, or two or more polyvalent metal ions may be used in combination.

The polyvalent metal ion content may be up to 3000 ppm, and preferably from 10-2000 ppm, in the aqueous dispersion.

The polyvalent metal ion may be produced by mixing with the aqueous medium a salt such as a nitric acid salt, sulfuric acid salt or acetic acid salt or a chelate containing a polyvalent metal element, and it may also be produced by mixing an oxide of a polyvalent metal element. There may also be used a compound that produces a monovalent metal ion when mixed with the aqueous medium, but whose ion becomes a polyvalent metal ion by the oxidizing agent. Of these various salts and chelates, iron nitrate is preferred because of its particularly excellent effect of improving the removal rate.

Examples

The present invention will now be explained in further detail by way of examples.

[1] Preparation of aqueous dispersions containing abrasive comprising inorganic particles or composite particles

(1) Preparation of aqueous dispersions containing inorganic particles

(a) Preparation of aqueous dispersions containing fumed silica or fumed alumina

After dispersing 2 kg of fumed silica particles (product name: "Aerosil #50", Nihon Aerosil Co., Ltd.) or fumed alumina particles (product name: "Aluminum Oxide C", Degusa Corp.) in an ultrasonic disperser in 6.7 kg of ion-exchange water, it was filtered with a filter having a 5 µm pore size, to prepare aqueous dispersions containing fumed silica particles or fumed alumina particles.

(b) Preparation of aqueous dispersions containing colloidal silica

After loading 70 g of ammonia water at a 25 wt% concentration, 40 g of ion-exchange water, 175 g of ethanol and 21 g of tetraethoxysilane into a 2-liter volume flask, the mixture was heated to 60° C while stirring at 180 rpm, and after continuing the stirring at this temperature for 2 hours, the mixture was cooled to obtain a colloidal silica/alcohol dispersion with a mean particle size of 0.23 µm. An evaporator was then used for several repetitions of a procedure in which the alcohol portion was removed while adding ion-exchange water to the dispersion at a temperature of 80° C, and the alcohol in the dispersion was thereby removed to prepare an aqueous dispersion with a solid concentration of 8 wt%.

(2) Preparation of aqueous dispersion containing abrasive comprising composite particles

{1} Aqueous dispersion comprising polymer particles

After charging 90 parts of methyl methacrylate, 5 parts of methoxypolyethyleneglycol methacrylate (trade name: "NK Ester M-90G", #400, product of Shinnakamura Chemical Industries Co., Ltd.), 5 parts of 4-vinylpyridine, 2 parts of an azo-based polymerization initiator (trade name "V50", product of Wako Junyaku Co., Ltd.) and 400 parts of ion-exchange water into a 2-liter volume flask, the contents were heated to 70°C while stirring under a nitrogen gas atmosphere, for 6 hours of polymerization. This yielded an aqueous dispersion containing polymethyl methacrylate-based particles with a mean particle size of 0.15 µm, having amino group cations and polyethylene glycol chain-bearing functional groups. The polymerization yield was 95%.

{2} Aqueous dispersion comprising composite particles

After loading 100 parts of this aqueous dispersion containing 10 wt% polymethyl methacrylate-based particles which was obtained in {1} above into a 2-liter volume flask, 1 part of methyltrimethoxysilane was added and the mixture was stirred at 40°C for 2 hours. The pH was then adjusted to 2 with nitric acid to obtain aqueous dispersion (a). Also, the pH of an aqueous dispersion containing 10 wt% of colloidal silica particles (product name: "Snowtex O", product of Nissan Chemical Industries Co., Ltd.) was adjusted to 8 with potassium hydroxide to obtain aqueous dispersion (b). The zeta potential of the polymethyl methacrylate-based particles in aqueous dispersion (a) was +17 mV, and the zeta potential of the silica particles in aqueous dispersion (b) was -40 mV.

After then gradually adding 50 parts of aqueous dispersion (b) to 100 parts of aqueous dispersion (a) over a period of 2 hours and then mixing and stirring for 2 hours, there was obtained an aqueous dispersion containing particles consisting of silica particles adhered to the polymethyl methacrylate-based particles. Next, 2 parts of vinyltriethoxysilane was added to this aqueous dispersion, and after stirring for one hour, 1 part of tetraethoxysilane was added, and the mixture was heated to 60° C and then continually stirred for 3 hours and cooled to obtain an aqueous dispersion containing composite particles. The mean particle size of the composite particles was 0.18 µm, and the silica particles were adhered to 80% of the surface of the polymethyl methacrylate-based particles.

[2] Preparation of aqueous dispersions for chemical mechanical polishing

Prescribed amounts of the aqueous dispersions prepared in [1], (1) and (2) were each charged into a 1-liter volume polyethylene bottle, and the acid or base aqueous solutions listed in Tables 1 to 4 were added to the acid and base contents also listed in Tables 1 to 4 and thoroughly mixed therewith. Aqueous solutions of the organic compounds and oxidizing agents listed in Tables 1 to 4 were then added to the organic compound and oxidizing agent concentrations listed in Tables 1 to 4 while stirring. Next, an aqueous potassium hydroxide solution or nitric acid was added to adjust the pH to the values listed in Tables 1 to 4, after which ion-exchange water was added and the solutions were filtered with a 5 µm pore filter to obtain aqueous dispersions for chemical mechanical polishing for Examples 1 to 16 and Comparative Examples 1 and 2.

[3] Evaluation of aqueous dispersion performance

The aqueous dispersions for chemical mechanical polishing prepared in [2] were used to evaluate the polishing pad deterioration and the presence of pits and flattening on polishing surfaces. The polishing pad deterioration was evaluated based on the change in the removal rate with repeated polishing. The results are summarized in Tables 1 to 4.

(1) Removal rate

A Model "LM-15" by Lapmaster Corp. was used as the polishing apparatus (table diameter: 380 mm) to polish copper film-coated wafers under the following conditions.

Table rotation speed and head rotation speed: 45 rpm; Polishing pressure, : 250 g/cm$^2$; Aqueous dispersion supply rate: 50 cc/min; Polishing pad: Two-layer structure of Product No. IC1000/SUBA400, by Rodel-Nitta Co., Ltd.

Three minutes of polishing was carried out 10 times, for a total of 30 minutes. After each polishing, the wafer was removed from the table, washed and dried, and the copper film thickness was measured to calculate the removal rate defined in the equation shown below. No dressing of the polishing pad was carried out during the 10-time polishing test.

Removal rate (Å/min) = (thickness of copper film before polishing - thickness of copper film after polishing)/polishing time.

(2) Presence of pits on polishing surface

The surface of each copper film after polishing was observed with a scanning electron microscope, to determine whether there were any pits on the polishing surface.

(3) Evaluation of flattening

The planarization efficiency ($T_1/T_0$) was calculated defined in the definition of flattening given above. $T_1$ and $T_0$ were measured using a profilometer (Model "P-10" by KLA-Tencor Corp. ) . The amount of polishing of the copper film was determined by measuring the thickness of the copper film before and after polishing.

The copper film-coated wafers used for evaluation in (1), (2) and (3) were evaluated for flatness at sections of 200 μm pitch (wiring width: 100 μm, spacer width: 100 μm, t = 15000 Å, $T_0$ = 7000 Å) using a model "931CMP006" by SEMATECH Corp. The test piece produced from cutting the above-mentioned wafer to 3.3 cm square was used for polishing and evaluation. For (1) and (3), the sheet resistance value was measured with a resistance measuring instrument (Model " Σ -10" by NPS Corp.), and the thickness of the copper film was calculated from the sheet resistance value and the copper film resistivity (listed value).

Thickness (Å) of copper film = [sheet resistance value ($\Omega/cm^2$) $\times$ copper resistivity ($\Omega/cm$)] x 10$^8$

Table 1

| | | Examples | | | | |
|---|---|---|---|---|---|---|
| | | 1 | 2 | 3 | 4 | 5 |
| Abrasive | Type | #50 Silica | | | | |
| | (Parts) | 5 | | | | |
| Organic compound | Type | bipyridyl | | | biphenol | 2-vinylpyridine |
| | (Parts) | 0.02 | | | 0.02 | 0.1 |
| Acid or base | Type | maleic acid | | | | ammonium malonate |
| | (Parts) | 1 | 0.5 | 1 | | 1 |
| Oxidizing agent | Type | hydrogen peroxide | | | | |
| | (Parts) | 0.1 | 0.05 | 0.1 | | 0.3 |
| pH adjustor | | potassium hydroxide | nitric acid | potassium hydroxide | | |
| pH | | 8 | 5 | 10.5 | 8 | 8.5 |
| Polishing rate ($\text{Å/min}$) | 1st time($S_1$) | 1250 | 1170 | 1160 | 1145 | 1085 |
| | 10th time($S_{10}$) | 1240 | 1170 | 1165 | 1140 | 1070 |
| | ($S_{10}/S_1$) | 0.992 | 1.000 | 1.004 | 0.996 | 0.986 |
| Pits | | Absent | | | | |
| Planarization efficiency ($T_1/T_0$) | | 0 | 0 | 0.01 | 0 | 0.001 |

Table 2

| | | Examples | | | Comparative Examples |
|---|---|---|---|---|---|
| | | 6 | 7 | 8 | 1 |
| Abrasive | Type | #50 Silica | alumina | #50 Silica | #50 Silica |
| | (Parts) | 5 | 3 | 5 | 5 |
| Organic compound | Type | 7-hydroxy-5-methyl-1,3,4-triazaindolizine | | | |
| | (Parts) | 0.3 | 0.4 | 0.2 | |
| Acid or base | Type | ammonium malonate | | potassium malonate | ammonium malonate |
| | (Parts) | 1 | 0.5 | 0.5 | 1 |
| Oxidizing agent | Type | hydrogen peroxide | | ammonium persulfate | hydrogen peroxide |
| | (Parts) | 0.3 | 0.3 | 0.5 | 0.3 |
| pH adjustor | | potassium hydroxide | | | potassium hydroxide |
| pH | | 8 | 8.5 | 8 | 8 |
| Polishing rate (Å/min) | 1st time($S_1$) | 3420 | 990 | 1220 | 1230 |
| | 10th time($S_{10}$) | 3450 | 975 | 1210 | 245 |
| | ($S_{10}/S_1$) | 1.009 | 0.984 | 0.992 | 0.199 |
| Pits | | Absent | | | Present |
| Planarization efficiency ($T_1/T_0$) | | 0.002 | 0.001 | 0 | 0.330 |

Table 3

| | | Examples | | | |
|---|---|---|---|---|---|
| | | 9 | 10 | 11 | 12 |
| Abrasive | Type | alumina | | #50 Silica | |
| | (Parts) | 3 | | 5 | |
| Organic compound | Type | 4−vinylpyridine | 2−vinylpyridine | 4−vinylpyridine | biphenol |
| | (Parts) | 0.3 | 0.6 | 0.3 | 0.2 |
| Acid or base | Type | — | | | |
| | (Parts) | — | | | |
| Oxidizing agent | Type | ammonium persulfate | | hydrogen peroxide | |
| | (Parts) | 0.3 | | 0.5 | |
| Ammonia (parts) | | — | | 0.8 | 0.9 |
| pH adjustor | | potassium hydroxide | | | |
| pH | | 8.1 | 8.5 | 8.3 | 8.1 |
| Polishing rate ($\text{Å/min}$) | 1st time($S_1$) | 3200 | 3450 | 3050 | 2950 |
| | 10th time($S_{10}$) | 3190 | 3450 | 3070 | 2980 |
| | ($S_{10}/S_1$) | 0.997 | 1.000 | 1.007 | 1.010 |
| Pits | | Absent | | | |
| Planarization efficiency ($T_1/T_0$) | | 0.03 | 0 | 0 | 0.005 |

EP 1 138 734 A2

Table 4

| | | Examples | | | |
|---|---|---|---|---|---|
| | | 13 | 14 | 15 | 16 |
| Abrasive | Type | colloidal silica | | composite particles | |
| | (Parts) | 5 | | 5 | |
| Organic compound | Type | 7-hydroxy-5-methyl-1,3,4-triazaindolizine | | | salicylaldoxime |
| | (Parts) | 0.2 | 0.3 | 0.2 | 0.1 |
| Acid or base | Type | ammonium malonate | | | |
| | (Parts) | 0.5 | | | |
| Oxidizing agent | Type | hydrogen peroxide | | | |
| | (Parts) | 0.3 | | | |
| Emalgen 120 (parts) | | — | 0.005 | — | |
| pH adjustor | | potassium hydroxide | | | |
| pH | | 8 | | | |
| Polishing rate ($\text{Å}/\text{min}$) | 1st time($S_1$) | 3370 | 3400 | 3530 | 3780 |
| | 10th time($S_{10}$) | 3360 | 3410 | 3550 | 3770 |
| | ($S_{10}/S_1$) | 0.997 | 1.003 | 1.006 | 0.997 |
| Pits | | Absent | | | |
| Planarization efficiency ($T_1/T_0$) | | 0.007 | 0 | 0.009 | 0.008 |

The results shown in Tables 1 to 4 demonstrate that in Examples 1 to 16, there was virtually no change in the removal rates between the first polishing and the tenth polishing and therefore no reduction in the removal rates, i.e. no deterioration in the polishing pads, irrespective of the type and content of the organic compound, the type, content or even the absence of the acid or base, the type and content of the oxidizing agent, or the pH. On the other hand, in Comparative Example 1 which contained no organic compound, the removal rate was reduced to about 1/5 by the tenth polishing compared to the first polishing, thus indicating a large deterioration in the polishing pad.

In Examples 1 to 16, almost no pits were observed on the polishing surfaces, but considerable polishing pits were found to have occurred in Comparative Example 1. The planarization efficiency in Examples 1 to 16 was from 0-0.01 except in Example 9 it was 0.03, indicating sufficient flatness for the copper film surfaces. In Comparative Example 1, however, the planarization efficiency was 0.33, which was much greater than Example 9 and represented a lack of flatness.

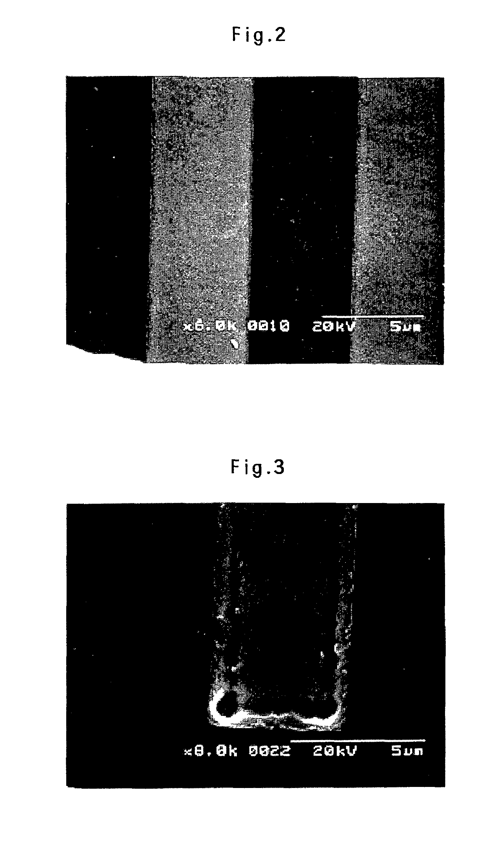

Fig. 2 is a photograph at 8000x magnification taken while observing the polishing surface of Example 6 with a scanning electron microscope, and Fig. 3 is a similar photograph taken of the polishing surface of Comparative Example 1. Fig. 2 shows absolutely no pits in the polishing surface, whereas the aqueous dispersion of Comparative Example 1 which did not contain a specific organic compound exhibited considerable pits as shown in Fig. 3; the action and effect of the specific organic compounds is therefore clearly supported.

It is an object of the present invention to provides an aqueous CMP dispersion with an adequately high initial removal rate, and which, even after repeated polishing, exhibits at least one, and preferably two or more, of the following functions and effects: (1) reduction of performance of polishing pads is suppressed and an adequate removal rate is maintained, (2) generation of pits on polishing surfaces is inhibited, and (3) uneven sections on polishing surfaces are flattened, and satisfactory finished surfaces can be formed with high precision. The aqueous CMP dispersion comprises an abrasive, an organic compound and water. The organic compound with an effect of suppressing reduction of performance of polishing pads may be biphenol, bipyridyl, vinylpyridine, adenine or the like. The organic compound with an effect of inhibiting generation of pits on polishing surfaces may be biphenol, bipyridyl, vinylpyridine, hypoxanthine or the like. The organic compound with an effect of flattening uneven sections on polishing surfaces may be biphenol, bipyridyl, vinylpyridine, salicylaldoxime or the like. The aqueous CMP dispersion of the present invention that contains specific organic compounds has at least one and especially two functions and effects from among that of suppressing reduction of performance of polishing pads, that of suppressing void wearing of polishing surfaces and that of flattening polishing surfaces, as well as a combination of these three functions and effects, even with repeated polishing. The aqueous CMP dispersion is particularly useful for polishing of copper films, and can form satisfactory finished surfaces with high precision.

## Claims

1. An aqueous dispersion for chemical mechanical polishing comprising an abrasive, an organic compound with an effect of suppressing reduction of performance of polishing pads, and water, the aqueous dispersion for chemical mechanical polishing being **characterized in that** said organic compound is at least one from among (1) biphenol, (2) bipyridyl, (3) vinylpyridine, (4) adenine, (5) a heterocyclic compound with a heteropentacycle, with no benzene ring forming the skeleton, and with a functional group, (6) a heterocyclic compound with a heteropentacycle, with a benzene ring forming the skeleton and with a functional group containing no sulfur atoms, (7) a heterocyclic compound with a heterohexacycle bearing two or more hetero atoms and with either or both a functional group and/or a benzene ring forming the skeleton, and a derivative of any of compounds (1) through (7).

2. An aqueous dispersion for chemical mechanical polishing according to Claim 1, wherein the heterocyclic compound with a heteropentacycle, with no benzene ring forming the skeleton, and with a functional group is at least one selected from among 7-hydroxy-5-alkyl-1,3,4-triazaindolizine, 2-amino-1,3,4-thiadiazole, 1H-tetrazole-1-acetic acid, 5-alkyl-1,3,4-thiadiazole-2-thiol, 4-amino-1,2,4-triazole, 5-amino-1H-tetrazole, 2-mercaptothiazoline and 4-amino-3-hydrazino-5-mercapto-1,2,4-triazole, said heterocyclic compound with a heteropentacycle, with a benzene ring forming the skeleton and with a functional group containing no sulfur atoms is either or both 2-aminobenzothiazole and/or 2-amino-6-alkylbenzothiazole, and said heterocyclic compound with a heterohexacycle bearing two or more hetero atoms and with either or both a functional group and/or a benzene ring forming the skeleton is at least one from among 3-amino-5,6-dialkyl-1,2,4-triazine, 2,3-dicyano-5-alkylpyrazine, 2,4-diamino-6-diallylamino-1,3,5-triazine and phthalazine.

3. An aqueous dispersion for chemical mechanical polishing **characterized by** comprising an abrasive, an organic compound with an effect of inhibiting generation of pits on polishing surfaces, and water.

4. An aqueous dispersion for chemical mechanical polishing according to Claim 3, wherein said organic compound is at least one from among (1) biphenol, (2) bipyridyl, (3) vinylpyridine, (4) hypoxanthine, (5) guanine, (6) salicylaldoxime, (7) a compound with a total of two or more amino groups and/or hydroxyl groups bonded to an alkylene group, (8) a compound with a total of two or more amino groups and/or hydroxyl groups bonded to a benzene ring, (9) a heterocyclic compound with a heteropentacycle and with no benzene ring forming the skeleton, (10) a heterocyclic compound with a heteropentacycle and with a benzene ring forming the skeleton, (11) a heterocyclic compound with a heterohexacycle bearing two or more hetero atoms and with either or both a functional group and/or a benzene ring forming the skeleton, and a derivative of any of compounds (1) through (11).

5. An aqueous dispersion for chemical mechanical polishing according to Claim 4, wherein said compound with a total of two or more amino groups and/or hydroxyl groups bonded to an alkylene group is phenylenediamine, said compound with a total of two or more amino groups and/or hydroxyl groups bonded to a benzene ring is at least one from catechol and aminophenol, said heterocyclic compound with a heteropentacycle and with no benzene ring forming the skeleton is at least one selected from among 7-hydroxy-5-alkyl-1,3,4-triazaindolizine, 2-amino-1,3,4-thiadiazole, 1-(2-dialkylaminoethyl)-5-mercaptotetrazole, bismuthiol, 5-alkyl-1,3,4-thiadiazole-2-thiol, 3-mercapto-1,2,4-triazole, 4-amino-1,2,4-triazole, 5-amino-1H-tetrazole and triazole, said heterocyclic compound with a heteropentacycle and with a benzene ring forming the skeleton is at least one from among 5-alkyl-1H-benzotriazole, 2-(2-benzotriazolyl)-p-cresol, 2,1,3-benzothiadiazole, benzimidazole, benzotriazole, mercaptobenzothiazole and benzofloxane, and said heterocyclic compound with a heterohexacycle bearing two or more hetero atoms and with either or both a functional group and/or a benzene ring forming the skeleton is at least one from among benzoguanamine, phthalazine and thiocyanuric acid.

6. An aqueous dispersion for chemical mechanical polishing **characterized by** comprising an abrasive, an organic compound with an effect of flattening uneven sections on polishing surfaces, and water.

7. An aqueous dispersion for chemical mechanical polishing according to Claim 6, wherein said organic compound is at least one from among (1) biphenol, (2) bipyridyl, (3) vinylpyridine, (4) salicylaldoxime, (5) a compound with a total of two or more amino groups and/or hydroxyl groups bonded to an alkylene group, (6) a compound with a total of two or more amino groups and/or hydroxyl groups bonded to a benzene ring, (7) a heterocyclic compound with a heteropentacycle, with no benzene ring forming the skeleton, and with a functional group, (8) a heterocyclic compound with a heteropentacycle, with a benzene ring forming the skeleton and with a functional group, (9) a heterocyclic compound with a heterohexacycle bearing two or more hetero atoms and with either or both a functional group and/or a benzene ring forming the skeleton, and a derivative of any of compounds (1) through (9).

8. An aqueous dispersion for chemical mechanical polishing according to Claim 7, wherein said compound with a total of two or more amino groups and/or hydroxyl groups bonded to an alkylene group is phenylenediamine, said compound with a total of two or more amino groups and/or hydroxyl groups bonded to a benzene ring is at least one from catechol and aminophenol, said heterocyclic compound with a heteropentacycle, with no benzene ring forming the skeleton and with a functional group is at least one selected from among 7-hydroxy-5-alkyl-1,3,4-triazaindolizine, 2-amino-1,3,4-thiadiazole, 4,5-dicyanoimidazole, 5-alkyl-1,3,4-thiadiazole-2-thiol, 1-phenyl-5-mercapto-1H-tetrazole, 2-amino-4,5-dicyano-1H-imidazole, 4-amino-1,2,4-triazole, 5-amino-1H-tetrazole, 3-mercapto-4-methyl-4H-1,2,4-triazole and 1H-tetrazole, said heterocyclic compound with a heteropentacycle, with a benzene ring forming the skeleton and with a functional group is at least one from among mercaptobenzothiazole, benzofloxane and 2,1,3-benzothiadiazole, and said heterocyclic compound with a heterohexacycle bearing two or more hetero atoms and with either or both a functional group and/or a benzene ring forming the skeleton is phthalazine.

9. An aqueous dispersion for chemical mechanical polishing **characterized by** comprising an abrasive, an organic compound with an effect of suppressing reduction of performance of polishing pads and an effect of inhibiting generation of pits on polishing surfaces, and water.

10. An aqueous dispersion for chemical mechanical polishing **characterized by** comprising an abrasive, an organic compound with an effect of suppressing reduction of performance of polishing pads and an effect of flattening uneven sections on polishing surfaces, and water.

11. An aqueous dispersion for chemical mechanical polishing **characterized by** comprising an abrasive, an organic compound with an effect of inhibiting generation of pits on polishing surfaces and an effect of flattening uneven sections on polishing surfaces, and water.

**12.** An aqueous dispersion for chemical mechanical polishing **characterized by** comprising an abrasive, an organic compound with an effect of suppressing reduction of performance of polishing pads, an effect of inhibiting generation of pits on polishing surfaces and an effect of flattening uneven sections on polishing surfaces, and water.

**13.** An aqueous dispersion for chemical mechanical polishing according to any one of Claims 9 to 12, wherein said organic compound is at least one from among (1) biphenol, (2) bipyridyl, (3) vinylpyridine, (4) hypoxanthine, (5) adenine, (6) guanine, (7) salicylaldoxime, (8) copperon, (9) cysteine, (10) thiourea, (11) a compound with a total of two or more amino groups and/or hydroxyl groups bonded to an alkylene group, (12) a compound with a total of two or more amino groups and/or hydroxyl groups bonded to a benzene ring, (13) a heterocyclic compound with a heteropentacycle and with no benzene ring forming the skeleton, (14) a heterocyclic compound with a heteropentacycle and with a benzene ring forming the skeleton, (15) a heterohexacyclic compound bearing two or more hetero atoms, and a derivative of any of compounds (1) through (15).

**14.** An aqueous dispersion for chemical mechanical polishing according to Claim 13, wherein said organic compound is at least one from among(1) biphenol, (2) bipyridyl, (3) vinylpyridine, (4) hypoxanthine, (5) adenine, (6) guanine, (7) a heterocyclic compound with a heteropentacycle, with no benzene ring forming the skeleton, and with a functional group, (8) a heterocyclic compound with a heteropentacycle, with a benzene ring forming the skeleton, and with a sulfur-lacking functional group, (9) a heterohexacyclic compound bearing two or more hetero atoms and either or both a functional group and/or a benzene ring forming the skeleton, and a derivative of any of compounds (1) through (9).

**15.** An aqueous dispersion for chemical mechanical polishing according to Claim 9 or 10, wherein said organic compound is at least one from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

**16.** An aqueous dispersion for chemical mechanical polishing according to Claim 11, wherein said organic compound is at least one from among bipyridyl, biphenol, vinylpyridine, salicylaldoxime, 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine, 5-amino-H-tetrazole, mercaptobenzothiazole, benzofloxane, 2,1,3-benzothiadiazole, catechol and aminophenol.

**17.** An aqueous dispersion for chemical mechanical polishing according to Claim 12, wherein said organic compound is at least one from among 7-hydroxy-5-alkyl-1,3,4-triazaindolizine, 2-amino-1,3,4-thiadiazole, 5-alkyl-1,3,4-thiadiazole-2-thiol, 4-amino-1,2,4-triazole, phthalazine and 5-amino-H-tetrazole.

**18.** An aqueous dispersion for chemical mechanical polishing according to any one of Claims 1 to 17, wherein the ratio ($S_{10}/S_1$) of the tenth removal rate ($S_{10}$) to the first removal rate ($S_1$) for 10 repeated chemical mechanical polishing operations of a copper film under the following conditions is 0.9 or greater.

Polishing conditions: Polishing pressure, 250 g/cm$^2$; Table rotation speed, 45 rpm; head rotation speed, 45 rpm; Aqueous dispersion supply rate, 50 ml/min; Polishing time, 3 minute; Porous polyurethane polishing pad.

**19.** An aqueous dispersion for chemical mechanical polishing according to any one of Claims 1 to 18, wherein said metal film is a copper film.

Fig. 1

Wiring material surface before CMP

Wiring material | $T_0$ | Wiring material

$t$

$T_1$

Wiring material surface after CMP

0.2t

Insulating film | Wiring material | Insulating film

Wafer

## Fig.2

## Fig.3